# EUROPEAN PATENT APPLICATION

(11) **EP 4 687 379 A1**
(43) Date of publication of application: **04.02.2026**
(21) Application number: 24306313.8
(22) Date of filing: 02.08.2024
(51) Int. Cl.: H05K 7/20, G06F 1/20

(54) **OPTIMIZED EVAPORATIVE DRY COOLING ARRANGEMENT AND PROCESS FOR A DATACENTER**

(71) Applicant: OVH, 59100 Roubaix (FR)
(72) Inventor: CHEHADE, Ali, 59283 Moncheaux (FR); HNAYNO, Mohamad, 59100 Roubaix (FR)
(74) Representative: BCF Global

(57) **Abstract**

A datacenter dry cooling system and method for cooling a heat-generating source are provided and directed to maximizing the absorption of cooling water applied to an evaporating pad for maximum evaporation and ambient air cooling while eliminating any leakages resulting therefrom. The evaporating pad is disposed on an air-to-liquid heat exchanger panel supplied by an evaporating cooling water distribution arrangement for applying the controlled amount of cooling water to the evaporating pad. The applied cooling water is to be completely evaporated while being exposed to ambient airflow to dissipate the thermal energy of the heat-generating sources. The evaporating pad includes corresponding temperature and/or humidity sensors for detecting temperature/humidity levels at an air outlet surface and a temperature and humidity sensor at an air inlet surface. A controller communicatively-coupled to the temperature and humidity sensors and evaporating cooling water arrangement controls the cooling water volume flow based on the detected temperature and humidity levels.

## Description

### FIELD

The present technology generally relates to the field of datacenter cooling measures and, in particular, to an evaporative cooling arrangement for a dry cooling system.

### BACKGROUND

Dry coolers and other heat exchanger systems operate to dissipate thermal energy from a cooling fluid (e.g., water) circulating therethrough to the ambient environment. For example, in a datacenter, a dry cooler can be used to cool heated water extracted from within the datacenter (e.g., water circulated through water blocks coupled to heat-generating electronic components).

In order to improve the efficiency of heat exchanger systems, some arrangements implement direct spray evaporative techniques to precool the temperature of the ambient air that flows through the heat exchanger system. For example, in some cases, a water spraying system (i.e., an atomizer) is placed at the air inlet of a dry cooler to spray water and increase the humidity level of the ambient air, thereby reducing its temperature. Other adiabatic cooling implementations also include for instance, evaporating pads in which water is applied to ambient air prior to entering the heat exchanger system or evaporating pads in which water is applied directly thereon.

However, in use, these implementations have experienced some drawbacks. For instance, these implementations typically employ a multitude of sensors, detectors, hardware, valves, and electronic components to control the water flow. Also, using direct spray techniques may consume a large volume of water, which negatively impacts the Water Usage Effectiveness (WUE) of such techniques and may also promote the dispersion of pathogenic bacteria, such as Legionella. Additionally, not all the water applied to the evaporating pads is absorbed and dissipated into the ambient air, thereby resulting in inconsistent cooling, temperature fluctuations, dust/contaminant buildup, and increased energy and water consumption to rectify these issues.

Therefore, even though the cooling implementations and techniques noted above provide certain benefits, further improvements that alleviate at least some of the drawbacks of these cooling implementations/techniques are still desirable.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

Embodiments of the present technology have been developed based on certain drawbacks associated with conventional dry cooling techniques and implementations.

In one aspect of the present technology, there is provided a datacenter dry cooling process for cooling a heat-generating electronic processing source, the datacenter associated with a dry cooler unit that incorporates an air-to-liquid heat exchanger panel, an evaporating pad, and an evaporating cooling water distribution arrangement for applying cooling water to the evaporating pad, in which the method comprises: providing, at an air outlet surface of the evaporating pad, at least one temperature sensor for detecting temperature levels and/or at least one relative humidity sensor for detecting humidity levels; providing, at an air inlet surface of the evaporating pad, at least one temperature sensor and/or relative humidity sensor for detecting temperature levels and/or humidity levels on an air inlet surface of the evaporating pad; providing at least one sensor for detecting a leak from the evaporating pad; and providing a controller that is communicatively-coupled to the temperature and humidity levels sensors disposed at the air outlet and air inlet surfaces of the evaporating pad, the leak sensor, and the evaporating cooling water distribution arrangement.

In a related aspect of the present technology, the controller is configured to execute instructions for: receiving the detected temperature and humidity levels from the sensors disposed at the air outlet and air inlet surfaces of the evaporating pad and the leak sensor; determining whether a first detected temperature level from the air outlet surface is greater than a predetermined first threshold temperature value and, upon determining that the detected first temperature level is greater than the first threshold temperature value, adjusting a predetermined target volume flow rate of the evaporating cooling water distribution arrangement to a predetermined maximum flow rate; determining whether a second detected temperature level from the air outlet surface is greater than a second threshold temperature value and, upon determining that the detected temperature level is greater than the second threshold temperature value, adjusting the predetermined the target volume flow rate of the evaporating cooling water distribution arrangement to the predetermined maximum flow rate; and determining whether the second detected temperature level is less than a third threshold temperature value and, upon determining that the second detected temperature level is less than the third threshold temperature value, adjusting the predetermined the target volume flow rate of the evaporating cooling water distribution arrangement to a predetermined minimum flow rate.

In another related aspect of the present technology, the datacenter dry cooling process further comprises controlling a volume flow valve of the evaporative cooling water distribution arrangement for applying a controlled measured flow rate of the cooling water to the evaporating pad, by: determining whether a detected flow rate is greater than the recommended volume flow rate and, upon determining that the detected flow rate is greater than the recommended volume flow rate, adjusting the volume flow rate to a reduced level that is less than the detected flow; determining whether the reduced volume flow rate is less than the predetermined minimum flow rate and, upon determining that the reduced volume flow rate is less than the predetermined minimum flow rate, adjusting the volume flow rate to the predetermined minimum flow rate; determining whether the detected flow rate is less than the recommended volume flow rate and, upon determining that the detected flow rate is less than the recommended volume flow rate, adjusting the volume flow rate to an increased level that is greater than the detected flow rate; determining whether the increased volume flow rate level results in an opened state of the volume flow valve and, upon determining that the volume flow valve is in an open state, send an alert message indicating that the volume flow valve is in an open state but there exists an insufficient flow rate.

Within the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

Additionally, within the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

Relatedly, within the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but may not, necessarily include all of them.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1A illustrates a conceptual representation of a dry cooler unit, in accordance with the nonlimiting embodiments of the present technology;
FIG. 1B illustrates a high-level functional block general overview diagram of a dry cooling arrangement, in accordance with the nonlimiting embodiments of the present technology;
FIG. 2A illustrates an evaporative cooling water distribution arrangement, in accordance with the nonlimiting embodiments of the present technology;
FIG. 2B illustrates a cross-sectional view of an evaporative cooling pad and various sensors, in accordance with the nonlimiting embodiments of the present technology;
FIG. 3 illustrates a functional flow diagram providing the processing operations for adjusting the volume flow of the evaporative cooling water based on detected temperature values for the evaporative cooling water distribution arrangement of FIG. 2A, in accordance with non-limiting embodiments of the present technology;
FIG. 4A illustrates a functional flow diagram providing the processing operations for controlling a volume flow valve of the evaporative cooling water distribution arrangement of FIG. 2A, in accordance with non-limiting embodiments of the present technology;
FIG. 4B illustrates a functional flow diagram providing processing operations directed to discerning any required flow rate issues after fully opening the volume flow valve, in accordance with non-limiting embodiments of the present technology; and
FIG. 5 illustrates a functional block diagram of monitoring controller 500 configured to execute various processing operations, in accordance with an embodiment of the present technology.

It should be appreciated that, unless otherwise explicitly specified herein, the figures are not drawn to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the figures including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some embodiments of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

With this said, attention is directed to some non-limiting examples to illustrate various implementations of aspects of the present technology.

In the non-limiting disclosed embodiments of the present technology detailed below, a datacenter dry cooling system directed to cooling heat-generating electronic processing assemblies is presented. The dry cooling system incorporates an evaporating cooling water distribution arrangement for supplying evaporative cooling water to an evaporating pad of the dry cooling system. The dry cooling system further incorporates relatively humidity and/or temperature sensors to detect outside external ambient conditions as well as an electronic monitoring controller configured to control and provide the optimal volume flow of the evaporative cooling water applied to the evaporating pad based, at least in part, on the data provided by the temperature sensors and humidity sensors. In this manner, the disclosed embodiments provide an evaporative cooling water arrangement for a datacenter dry cooler unit that optimally controls the application of cooling water to evaporating pads to virtually prevent any cooling water leakages while, at the same time, substantially reducing the number of sensors, detectors, hardware, valves, and electronic components typically required by the prior art configurations to achieve the intended effect. This dry cooling arrangement further provides the added benefit of using an optimal amount of water to reduce large water consumption as well as achieve virtually 100% evaporation ratio with no water leakage.

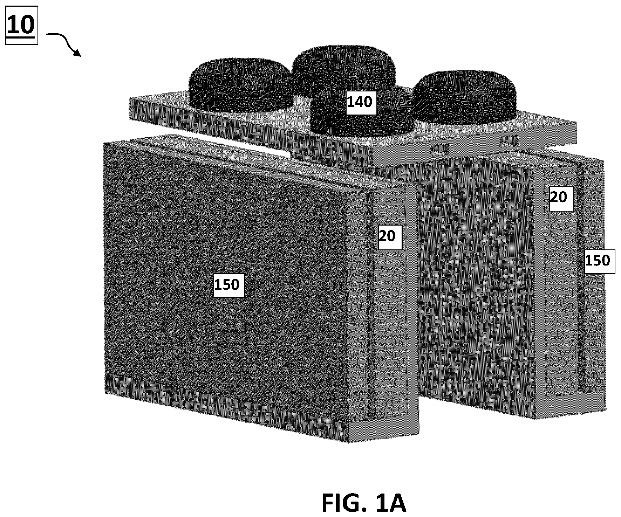

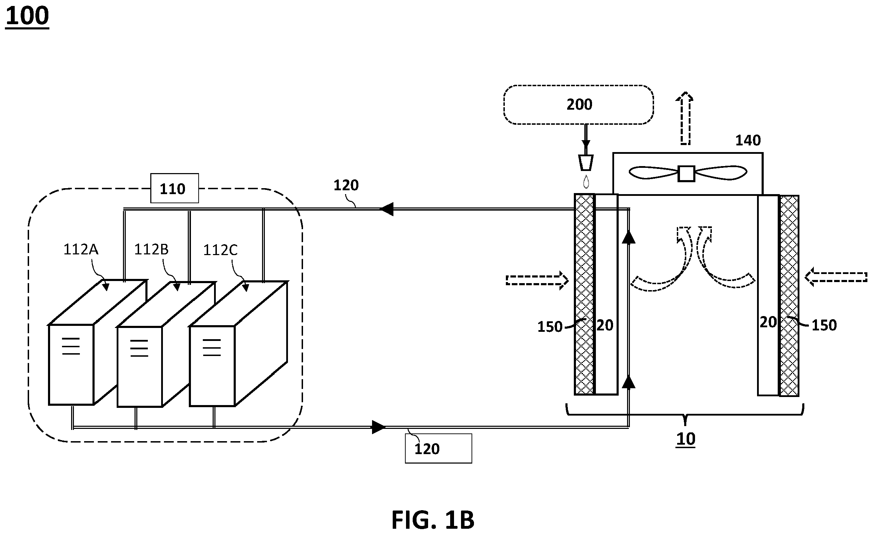

Accordingly, FIG. 1A illustrates a conceptual representation of a dry cooler unit **10** and FIG. 1B illustrates a high-level functional block general overview diagram of a dry cooling arrangement **100,** in accordance with the nonlimiting embodiments of the present technology. The dry cooler unit **10** may be located on any suitable support surface, such as, for example, the roof of a datacenter building or stable surface in close proximity to the datacenter. As shown, dry cooler unit **10** generally comprises the basic following components: at least one heat exchanger panel **20,** at least one fan assembly **140,** and at least one evaporating pad **150.**

The heat exchanger panel **20** operates to expel heated thermal energy of a cooling liquid, flowing through and warmed by rack-mounted heat-generating electronic processing assemblies, into the ambient environment. That is, the heat exchanger panel **20** is configured as a liquid-to-air heat exchanger, having an air inlet side (*not shown*) for receiving ambient air flow and an air outlet side (*not shown*) for expelling heated air. The heat exchanger panel **20** also incorporates cooling coils (*not shown*), in which warmed cooling liquid circulates therethrough via a cooling liquid closed loop **120.**

As indicated in FIG. 1B, the cooling liquid closed loop **120** conveys the cooling liquid to processing servers **112A-C** (collectively referred to as "heat source **110**") that house the rack-mounted heat-generating electronic processing assemblies (*not shown*)*.* The cooling liquid is supplied to liquid cooling blocks (*not shown*) in direct thermal contact to the heat-generating electronic processing components for cooling purposes. The cooling liquid absorbs the generated heat and the warmed cooling liquid is circulated, via the cooling liquid closed loop **120** back to the dry cooler unit **10** for extracting and dissipating the thermal energy therein and recooling the cooling fluid. It will be appreciated that the cooling liquid may comprise water, dielectric fluid, refrigerant fluid, diphasic fluid, or any other fluid suitable for collecting and discharging thermal energy.

The fan assembly **140** is disposed on an upper surface of the dry cooler unit **10** and is configured to forcibly cause ambient air flow throughout the dry cooler **10.** The fan assembly **140** comprises a plurality of fans located at an upper end of the dry cooler unit **10.** The fan assembly **140** includes respective motors (*not shown*) that drive each of the fans to rotate and forcibly pull ambient air from a lateral side of the dry cooler **10** towards an interior space of the dry cooler unit **10.** The heat exchanger panel **20** (and respective cooling coils) is exposed to the forcibly pulled-in ambient air. In turn, the thermal energy manifested by the warmed first cooling liquid circulating through the cooling coils is transferred, via the outlet side, and expelled vertically upwards from the dry cooler unit **10** into the ambient environment.

The evaporating pad **150** is positioned to directly abut an outer lateral surface of the heat exchanger panel **20.** The evaporating pad **150** is configured to absorb a cooling liquid applied thereto while enabling air flow to pass through the pad surface. The evaporating pad **150** comprises an air inlet surface (*not shown*) for receiving the air flow and an air outlet surface (*not shown*) for expelling the air flow. The evaporating pad **150** may be made of plastic material, cellulose, glass fibers, *etc.* to absorb the applied cooling liquid.

As will be described in greater detail below, the evaporating pad **150** operates to receive cooling water from an evaporative cooling water distribution arrangement **200.** The evaporative cooling arrangement **200** is configured to apply a specifically-controlled measured amount of evaporative cooling water, based on certain detected operational factors, to wet the evaporating pad **150** for optimal cooling performance while virtually eliminating any water leakages.

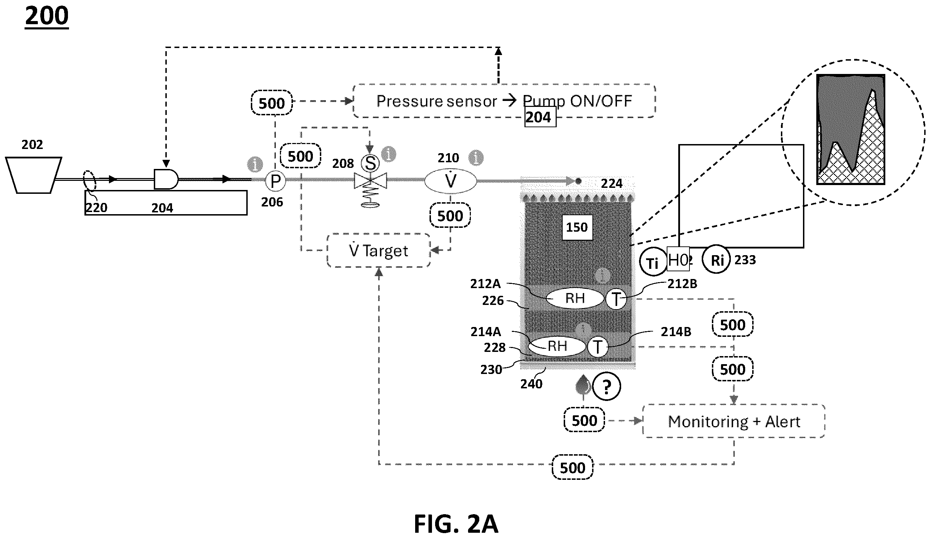

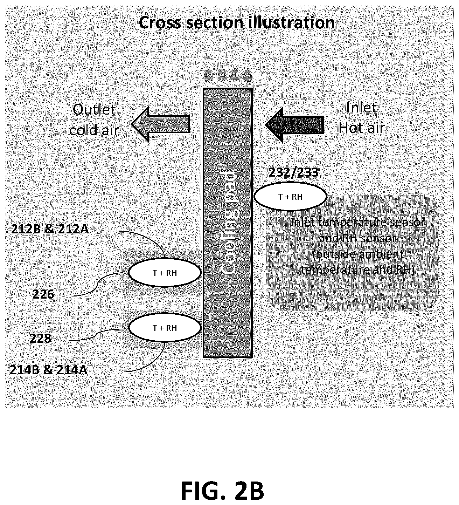

To this end, FIG. 2A and 2B illustrate an evaporative cooling water distribution arrangement **200,** in accordance with the nonlimiting embodiments of the present technology. The evaporative cooling water is supplied by source **202** via a distribution conduit **220** and a pump **204.** The pump **204** is configured to forcibly urge the flow of the evaporative cooling water throughout the distribution conduit **220.** It will be appreciated that the evaporative cooling water supplied by source **202** may comprise deionized water, osmosed water, or any other type of treated/processed water that is free from minerals or contaminants.

The pressure level of the flow of the evaporative cooling water is detected by pressure sensor **206.** As will be described in greater detail below, pressure sensor **206,** humidity sensors **212A, 214A, 233,** temperature sensors **212B, 214B, 232** and flow-rate sensor **210** are communicative-coupled to a monitoring controller **500** to report the respective detected water pressure data, relative humidity data, temperature data, and water flow data. The monitoring controller **500** is configured to process the data to determine whether the operations of certain components should remain the same, be subjected to adjustments, or turned off.

Provided that the pump **204** is allowed to continue operations, the distribution conduit **220** conveys the evaporative cooling water to a volume flow control valve **208.** The flow control valve **208** may comprise a solenoid-controlled valve, a pressure independent control valve (PICV), or an automatic balancing pressure control valve (ABQM). In an alternative configuration, a temperature sensor (*not shown*) may be incorporated before or after the control valve **208** to detect the temperature levels of the supplied water and may also be communicatively-coupled to the controller **500.** In this manner, if the temperature sensor detects that the temperature of the supplied water is "very low" the supplied water may be integrated with the cooling liquid closed loop **120** via a plate heat exchanger to lower the inlet water temperature to the dry cooler unit **10** and reduce the cooling demand. In other words, the low temperature of the water supplied to the cooling pads can be exploited to reduce the outlet temperature of the data center, thereby decreasing the cooling demand.

The distribution conduit **220** subsequently conveys the evaporative cooling water to a water distribution unit **224** configured to apply the cooling water to the evaporating pad **150.** The water distribution unit **224** may comprise a nozzle or a series of nozzles, a fluid discharge manifold, a sprayer, or any structure that uniformly dispenses the cooling water across the width dimension of a top surface of the pad **150.**

For purposes of illustration, the depicted embodiment indicates that the evaporating pad **150** is associated with humidity sensors **212A, 214A** and/or temperature sensors **212B, 214B** on the air outlet surface that measure the outside relative humidity and temperature levels that measures the temperature levels after the evaporative cooling pad. In various implementations, the evaporating pad **150** may be associated with only temperature sensors and only humidity sensors on the air outlet surface of the pad **150** or as will be described in greater detail below, a temperature sensor associated with a first band across the pad surface and a humidity sensor associated with a second band across the pad surface. In addition, there is provided an inlet temperature sensor **232** and inlet humidity sensor **233** that respectively measure the outside temperature and humidity levels before the evaporative cooling pad. Therefore, it should be appreciated that such alternative implementations are consistent with the scope of the disclosed concepts.

Returning to the illustrated embodiment of FIG. 2A, the air inlet and outlet surfaces of the evaporating pad **150** may implement a first monitoring band **226** across the width dimension of the evaporating pad **150** and a second monitoring band **228** across the width dimension of the evaporating pad **150** that is positioned lower than the first band **226** at the outlet surface of the evaporating pad **150.** By way of relative reference, the first monitoring band **226** is disposed below a halfway point of the evaporating pad **150** vertical dimension and the second monitoring band **228** is disposed below the first monitoring band **226** such that a spaced buffer band **230** is defined between the bottom of the second band **228** and the bottom surface of the evaporating pad **150.** The spaced buffer band **230** operates as an internal reservoir that absorbs any residual cooling water, via capillary action, from the bottom of the evaporating pad **150** that may otherwise result in leakages.

The relative positioning of the first and second monitoring bands **226, 228** noted above is based on the developer's observation that, while the cooling water is applied uniformly, the actual absorption of the cooling water is nonuniform throughout the evaporating pad **150.** That is, as conceptually represented in the circular insert of FIG. 2A, because of the material composition of the evaporating pad **150,** the absorption level of the cooling water along the pad is very irregular, as it varies along different areas of the evaporating pad **150.**

As best shown in the a cross-sectional view of FIG. 2B, the humidity sensor **212A** and/or temperature sensor **212B** are implemented along the first monitoring band **226** of the evaporating pad **150** while humidity sensor **214A** and/or temperature sensor **214B** are implemented along the second monitoring band **228** to report relative humidity and temperature data to the monitoring controller **500.** The implementation of humidity sensors **212A, 214A** and/or temperature sensors **212B, 214B** along the respective monitoring bands **226, 228** involves positioning the sensors at a predefined distance away from the evaporating pad **150,** surface so as not contact the pad **150.** For further clarity, the evaporating pad **150** being associated with humidity sensors **212A, 214A** and/or temperature sensors **212B** may be defined, in some embodiments, as a positioning of the humidity sensors **212A, 214A** and/or the temperature sensors **212B** proximate to, but not in contact with, the evaporating pad **150.** In some other embodiments, the evaporating pad **150** being associated with the humidity sensors **212A, 214A** and/or the temperature sensors **212B** may be defined as an incorporation of the humidity sensors **212A, 214A** and/or the temperature sensors **212B** within the evaporating pad **150.**

In this manner, the monitoring controller **500** is able to accurately monitor the relative humidity and temperature levels across the first and second monitoring bands **226, 228** in order to optimally control the application of cooling water to the evaporating pad **150** and virtually prevent any leakages dripping from the bottom of the evaporating pad **150.**

FIG. 2A also references that evaporative cooling water distribution arrangement **200** employs certain operations, such as pump control and monitoring/alert messaging as well as utilizes operational metrics, such as target volume flow V_{op-target}, Vₘᵢₙ, Vₘₐₓ, T_{mid}, T_{low-up}, and T_{low-down}. The T_{mid}, T_{low-up}, and T_{low-down} metrics may be a constant or a function of the outside humidity ***f***(RH) and/or temperature levels ***f***(T). Additionally, the distribution arrangement **200** further utilizes a theoretical target volume V_{theo-target} that has been derived from empirical data analyzed by the developers based on the outside relative humidity and/or outside temperature levels. These operational and theoretical metrics are utilized by the monitoring controller **500** to optimally control the application of cooling water to the evaporating pad **150.** Accordingly, an operational target volume V_{op-target} of the evaporative cooling water to be applied to the evaporating pad **150** may be formulated as a function of the outside relative humidity before the evaporative cooling pad (V_{target} = ***f***(RH)) and/or outside temperature levels before the cooling pad (V_{target} =***f***(T)) relative to a given heat load of the heat source **110** (*i.e.,* processing servers **112A-C**).

For purposes of clarity and tractability, the operational target volume V_{op-target}of the evaporative cooling water will be described in terms of the detected temperature levels (V_{target} = ***f***(T)). However, it should be appreciated that such temperature level descriptions equally apply to the utilization of detected relative humidity levels or a combination of both.

As such, the operational and theoretical metrics to be utilized by the the monitoring controller **500** to execute relevant control processes for evaporative cooling water distribution arrangement **200,** are defined as follows. First, the detected outside temperature along the first monitoring band **226** is represented as T_{mid} while target temperature T_{mid-target} relates to either a predetermined constant temperature value or a function of the outside temperature indicated as inlet temperature Tᵢ. The detected outside temperature along the second monitoring band **228** is represented as T_{low} having temperature levels that range from T_{low-down(min)} to T_{low-up(max)}, both of which are functions of the inlet temperature Tᵢ. Also, the minimum evaporative cooling water flow rate is represented as Vₘᵢₙ which constitutes a percentage of the theoretical target volume V_{theo-target} and the maximum evaporative cooling water flow rate is represented as Vₘₐₓ which constitutes a higher percentage of the theoretical target volume V_{theo-target}.

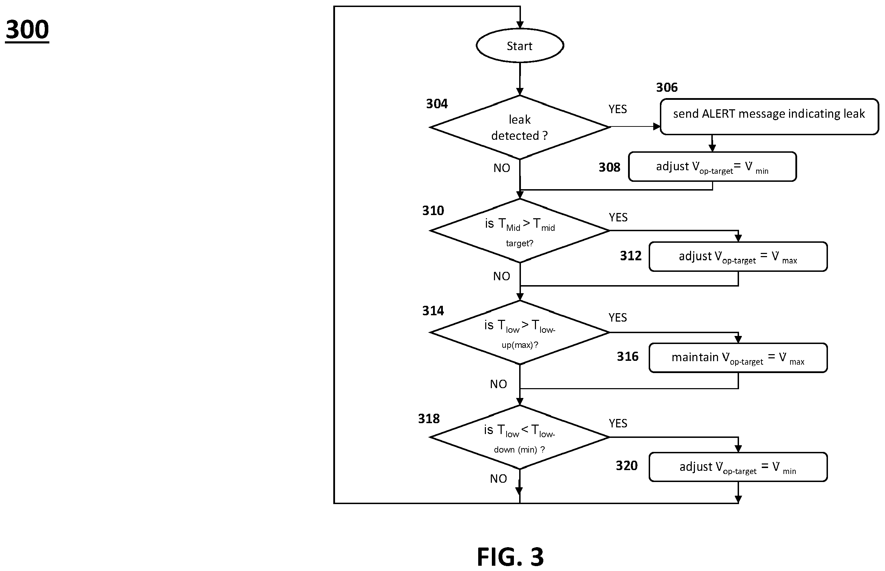

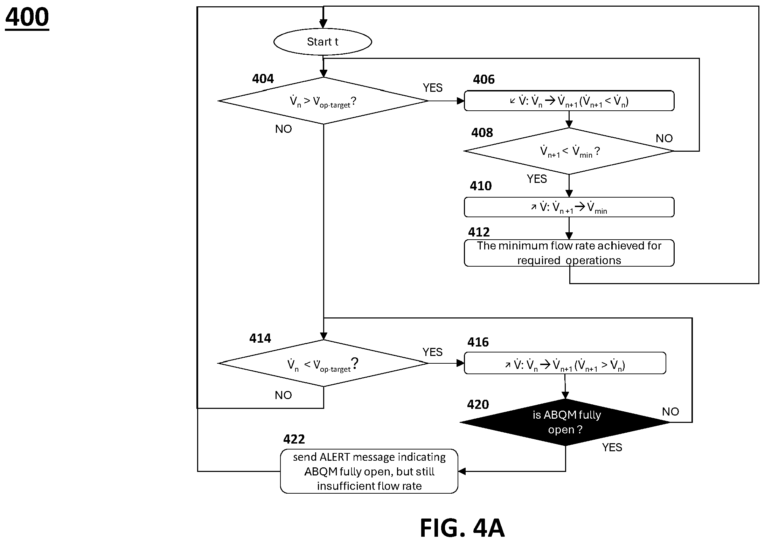

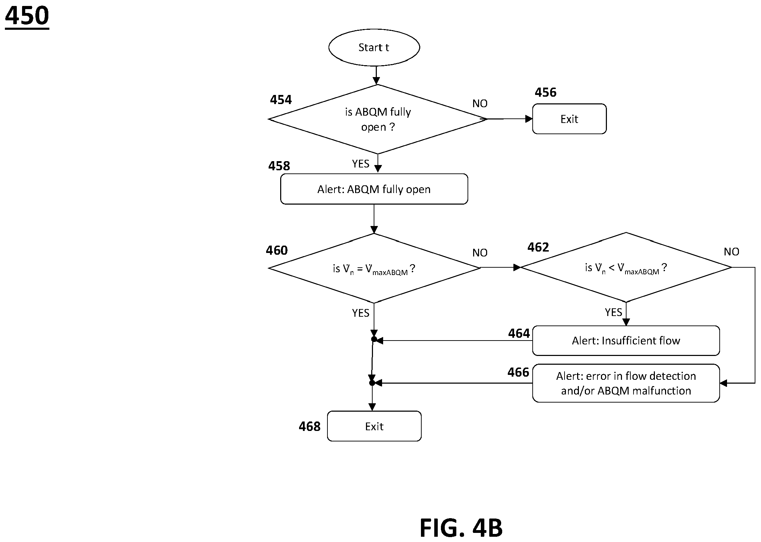

Armed with the noted operational and theoretical metrics, the control operations of monitoring controller **500** to execute the various processes of evaporative cooling water distribution arrangement **200** are described in detail relative to FIGs. 3, 4A, 4B, in accordance with non-limiting embodiments of the present technology.

To begin with, FIG. 3 illustrates a functional flow diagram providing processing operations **300** directed to adjusting the volume flow of the evaporative cooling water based on detected temperature values for the evaporative cooling water distribution arrangement **200** of FIG. 2A, in accordance with non-limiting embodiments of the present technology.

Process **300** commences with step **304** which determines whether a leak has been detected by a sensor disposed in the retention tray **240** located at the bottom of the heat exchanger **20.** The sensor may comprise a water sensor, a level sensor, or any kind of sensor capable of detecting the presence of water in pan **240.** In the event that a leak has been detected, the monitoring controller **500** transmits an alert message at step **306** and subsequently adjusts the operational volume flow V_{op-target} to Vₘᵢₙ at step **308.**

If no leak has been detected, process **300** determines, at step **310,** whether the T_{mid} detected temperature is greater than T_{mid-target}. As noted above, the target temperature T_{mid-target} metric value is based on a predetermined constant temperature value or as a function of the outside inlet temperature Tᵢ. Therefore, if the detected T_{mid} temperature value is greater that T_{mid-target}, the operational volume flow V_{op-target}is adjusted to the Vₘₐₓ level at step **312.** And, if not, process **300** advances to step **314.**

At step **314,** process **300** determines whether the detected T_{low} temperature is greater than the T_{low-up (max)}. As noted above, the T_{low-up (max)} metric value is determined as a function of the outside inlet temperature Tᵢ. Therefore, if the detected T_{low} temperature is greater than the T_{low-up(max)}, at step **316,** the operational volume flow V_{op-target} is maintained at the Vₘₐₓ level and, if not, process **300** progresses to step **318.**

At step **318,** process **300** determines whether the detected T_{low} temperature is less than the T_{low-down(min)} metric value. As also noted above, the T_{low-down(min)} metric value is determined as a function of the outside inlet temperature Tᵢ. As such, if the detected T_{low} temperature is less than the T_{low-up(min)}, at step **320,** the operational volume flow V_{op-target} is adjusted to the Vₘᵢₙ level.

After step **320,** process **300** returns back to the beginning to repeat the volume flow processing cycle. It will be appreciated that process **300** may be performed upon installation and may repeated continuously, at predetermined intervals, or upon detection of an anomaly.

By way of illustration, the graphs presented below indicate the patterns of the temperature and humidity levels in the first and second monitoring bands **226, 228** as a result of the operations of process **300.** For example, in the first band **226,** there is a constant mid-range temperature (*i.e*., "TemperatureMid" in the graph) and a constant mid-range relative humidity level (*i.e*, "HumidityMid" in the graph). In the second band **228,** at the end of the cooling phase, there is a sinusoidal pattern where the temperature oscillates between low and high values (*i.e.,* wet and dry cycles: "TemperatureLow"), and the humidity oscillates between high and low relative humidity levels (*i.e.,* wet and dry cycles: "HumidityLow").

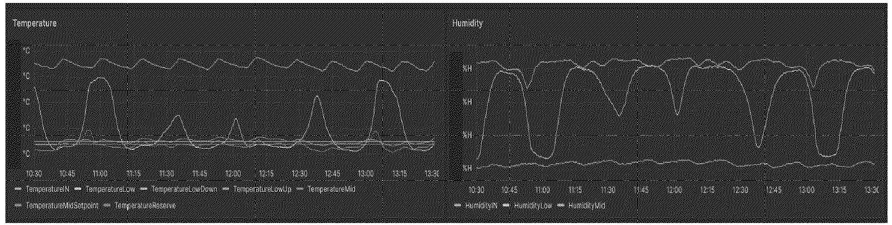

FIG. 4A illustrates a functional flow diagram providing processing operations **400** directed to controlling a volume flow valve **208** of the evaporative cooling water distribution arrangement **200** of FIG. 2A for providing a measured cooling water volume flow to the evaporating pad **150,** in accordance with non-limiting embodiments of the present technology. As noted above, the volume flow valve **208** may comprise a solenoid-controlled valve, a pressure independent control valve (PICV), or an automatic balancing pressure control valve (ABQM). For purposes of tractability, FIG. 4A refers to an ABQM valve which, should not in anyway, be interpreted as being limiting.

Process **400** commences with step **404** which determines whether the detected flow rate Vₙ is greater than the recommended operational volume flow V_{op-target}. If so, at step **406,** the detected flow rate Vₙ is reduced to a flow rate Vₙ₊₁ that is less than the detected flow rate Vₙ. Then at step **408,** it is determined whether the reduced flow rate Vₙ₊₁ is less than Vₘᵢₙ and, if not, process **400** returns back to step **404** to recheck whether the detected flow rate Vₙ is still greater than the recommended operational volume flow V_{op-target} and keeps iterating until flow rate Vₙ₊₁ is less than Vₘᵢₙ And, upon the reduced flow rate Vₙ₊₁ reaching a volume level that is less than Vₘᵢₙ then, at step **410,** the flow rate Vₙ₊₁ is adjusted to the minimum flow rate Vₘᵢₙ. And, at step **412,** it is confirmed that the minimum volume flow rate Vₘᵢₙ has been reached to comply with required operations. Process **400** then returns back to the beginning to repeat the entire volume flow valve **208** control processing cycle.

If back at step **404,** it is determined that the detected flow rate Vₙ is not greater than the recommended volume flow rate V_{target}, then step **414** determines whether Vₙ is less than V_{target}. If not, the determination is made that Vₙ is equal to V_{target}, and process **400** returns back to the beginning to repeat the entire volume flow valve **208** control processing cycle. If Vₙ is determined to be less than V_{target}, then process **400** progresses to step **416.**

At step **416,** the detected flow rate Vₙ is increased to a flow rate Vₙ₊₁ that is greater than the detected flow rate Vₙ. Then, at step **420,** process **400** determines whether the volume flow valve **208** is fully open and, if not, the process returns back to step **414** to repeat the checking of whether the detected flow rate is less than operational volume flow V_{op-target}. However, if at step **420** it is determined that the volume flow valve **208** is fully open, then process **400** at step **422,** forwards a warning message indicating that the volume flow valve **208** is fully open but there exists an insufficient flow rate. This message is provided to indicate that there may be a water supply, pump, and/or piping issue preventing the required flow rate for proper operations. Accordingly, process **400** returns back to the beginning to repeat the entire volume flow valve **208** control processing cycle. It will be appreciated that process **400** may be performed upon installation and may repeated continuously, at predetermined intervals, or upon detection of an anomaly.

FIG. 4B illustrates a functional flow diagram providing processing operations **450** directed to monitoring the evaporative cooling flow rate after fully opening the volume flow valve **208** to determine any flow rate issues, in accordance with non-limiting embodiments of the present technology. Again, for purposes of tractability, FIG. 4B refers to an ABQM valve which, should not in anyway, be interpreted as being limiting.

Process **450** commences at step **454,** to determine whether the volume flow valve **208** has been fully opened. If not, process **450** is exited at step **456.** However, if the volume flow valve **208** has been fully opened, process **450** progresses to step **458** to send an alert message indicating that the volume flow valve **208** is fully open.

Then, at step **460,** process **450** determines whether the detected flow rate Vₙ is equal to a maximum flow rate that can be accommodated by the volume flow valve V_{maxABQM}. And, if so, process **450** is exited at step **468.**

However, if the detected flow rate Vₙ is not equal to the maximum flow rate V_{maxABQM}, then at step **462,** process **450** determines if the detected flow rate Vₙ is less than the maximum flow rate V_{maxABQM}. If so, an alert message is sent indicating the condition of insufficient flow rate that requires investigation at step **464** and process **450** is exited at step **468.**

If the detected flow rate Vₙ is not less than the maximum flow rate V_{maxABQM}, which indicates that Vₙ is greater than the maximum flow rate V_{maxABQM}, then at step **466,** process **450** sends an alert message indicating the condition of an error in detected flow rate Vₙ detection and/or volume flow valve **208** malfunction that requires investigation and process **450** is exited at step **468.** It will be appreciated that process **450** may be performed upon installation and may repeated continuously, at predetermined intervals, or upon detection of an anomaly.

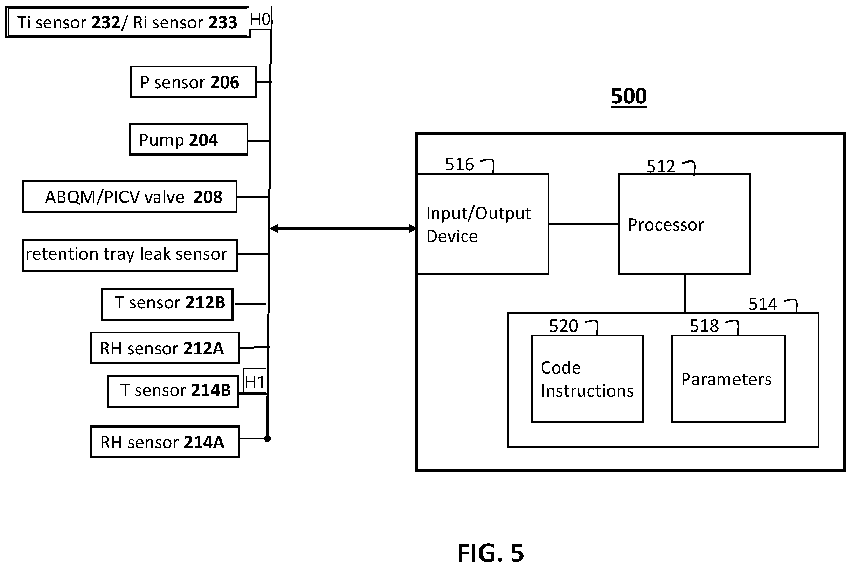

FIG. 5 illustrates a functional block diagram of monitoring controller **500** configured to execute the processing operations noted above, in accordance with an embodiment of the present technology.

As shown, the controller **500** comprises a processor or a plurality of cooperating processors (represented as a processor **512** for simplicity), a memory device or a plurality of memory devices (represented as a memory device **514** for simplicity), one or more input devices and one or more output devices, the input devices and the output devices being possibly combined in one or more input/output devices (represented as a single input/output device **516** for simplicity). The processor **512** is operatively connected to the memory device **514** and to the input/output device **516.** The memory device is configured to store a list **518** of relevant parameters. The memory device **514** may comprise a non-transitory computer-readable media for storing control logic instructions **520** that are executable by the processor **512** and, in particular, the executing process **300** for optimally controlling the application of cooling water to the evaporating pad **150.**

The processor **512** is communicatively coupled, via the input/output interface **516,** to the inlet temperature sensor **232** and inlet humidity sensor **233,** pressure sensor **206,** pump **204,** temperature sensors **212B, 214B,** relative humidity sensors **212A, 214A** for extraction of relevant data as well as operatively coupled to ABQM/PICV valve **208** and pressure sensor **206** for adjustment and control of disclosed elements. The processor **512** is configured to execute the control logic instructions **520** stored in the memory device **514** to implement the various above-described functions of the controller **500.**

It will be appreciated that in certain embodiments, the control logic instructions **520** of processor **512** may be further configured to evaluate the detected data received from the various temperature and humidity sensors noted above over a period of time to provide predictive and/or recommended operating control parameters of operatively coupled elements such as valve **208** and pump **204.** As such, the control logic instructions **520** may incorporate artificial intelligence (AI) methodologies that analyze the operational parameters of all detected sensors over time to provide adjustments/control of related elements to optimize evaporative water cooling operations based on empirical/historical data, such as, for example, time of day, weekdays, weekends, different seasons, *etc.*

With this said, the disclosed non-limiting embodiments provide an evaporative cooling water arrangement for a datacenter dry cooler unit that is configured to optimally control the application of cooling water to evaporating pads and virtually prevents any cooling water leakages while, at the same time, substantially reducing the number of sensors, detectors, hardware, valves, and electronic components required to achieve the intended effect by prior art configurations. And, furthermore, the cooling water arrangement promotes efficient water usage by minimizing wasted water.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A datacenter dry cooling method (300, 400, 450) for cooling a heat-generating electronic processing source, the datacenter associated with a dry cooler unit (10) that incorporates an air-to-liquid heat exchanger panel (20), an evaporating pad (150), and an evaporating cooling water distribution arrangement (200) for applying cooling water to the evaporating pad (150), the method comprising:
at an air outlet surface of the evaporating pad, detecting temperature levels by at least one temperature sensor (212B, 214B) and/or at least one relative humidity sensor (212A, 214A) for detecting humidity levels;
at an air inlet surface of the evaporating pad, detecting temperature levels by at least one temperature sensor (232) and/or humidity levels by a relative humidity sensor (233);
detecting a leak from the evaporating pad by at least one sensor; and
a controller (500) communicatively-coupled to the temperature and humidity levels sensors disposed at the air outlet and air inlet surfaces of the evaporating pad, the leak sensor, and the evaporating cooling water distribution arrangement (200), in which the controller (500) is configured to execute instructions for:
receiving the detected temperature and humidity levels from the sensors disposed at the air outlet and air inlet surfaces of the evaporating pad and the leak sensor;
determining whether a first detected temperature level (T_{mid}) from the air outlet surface is greater than a predetermined first threshold temperature value (T_{midtarget}) (st. 310) and, upon determining that the detected first temperature level is greater than the first threshold temperature value, adjusting a predetermined target volume flow rate (V_{target}) of the evaporating cooling water distribution arrangement (200) to a predetermined maximum flow rate (Vₘₐₓ) (st. 312);
determining whether a second detected temperature level from the air outlet surface (T_{low}) is greater than a second threshold temperature value (T_{lowupmax}) (st. 314) and, upon determining that the detected temperature level is greater than the second threshold temperature value, adjusting the predetermined the target volume flow rate (V_{target}) of the evaporating cooling water distribution arrangement (200) to the predetermined maximum flow rate (Vₘₐₓ) (st. 316); and
determining whether the second detected temperature level (T_{low}) is less than a third threshold temperature value (T_{lowdownmin}) (st. 318) and, upon determining that the second detected temperature level is less than the third threshold temperature value, adjusting the predetermined the target volume flow rate (V_{target}) of the evaporating cooling water distribution arrangement (200) to a predetermined minimum flow rate (Vₘᵢₙ) (st. 320).

2. The dry cooling method of claim 1, further comprising:
determining whether a leak has been detected (st. 304);
upon determining that a leak has been detected, sending an alert message indicating the detection of a leak (st. 306); and
adjusting a predetermined target volume flow rate (Vₘₐₓ) of the evaporating cooling water distribution arrangement (200) to the predetermined minimum flow rate (Vₘᵢₙ) (st. 308).

3. The dry cooling method of claims 1 or 2, wherein:
a first temperature and/or humidity sensor (212A, 212B) is disposed along a first monitoring band (226) on the air outlet surface of the evaporating pad (150) to provide the first detected temperature level (T_{mid}); and
a second temperature and/or humidity sensor (214A, 214B) disposed along a second monitoring band (228) on the air outlet surface of the evaporating pad (150) to provide the second detected temperature level (T_{low}),
wherein the second monitoring band (228) is positioned lower than the first monitoring band (226).

4. The dry cooling method of claim 3, wherein:
the determining that the first detected temperature level (T_{mid}) is greater than the first threshold temperature value (T_{midtarget}) (st. 310) corresponds to the temperature level detected by the first temperature sensor (212B) along the first monitoring band (226); and
the determining that the second detected temperature level (T_{low}) is greater than the second threshold temperature value (T_{lowupmax}) (st. 314) or less than the third threshold temperature value (T_{lowdownmin}) (st. 318) corresponds to the temperature level detected by the second temperature sensor (214B) along the second monitoring band (228).

5. The dry cooling method of anyone of claims 1 to 4, wherein:
the predetermined first threshold temperature value (T_{midtarget}) is based on an empirically-derived constant or an empirically-derived function dependent on the detected temperature level at the air inlet surface of the evaporating pad (Tᵢ); and
the second threshold temperature value (T_{lowupmax}), the third threshold temperature value (T_{lowdownmin}), the predetermined minimum flow rate (Vₘᵢₙ), and the predetermined maximum flow rate (Vₘₐₓ) are based on the empirically-derived function dependent on the detected temperature level (Tᵢ) or humidity level (Rᵢ) at the air inlet surface.

6. The dry cooling method of anyone of claims 1 to 5, further comprising controlling (400) a volume flow valve (208) of the evaporative cooling water distribution arrangement (200) for applying a controlled measured flow rate of the cooling water to the evaporating pad (150), by:
determining whether a detected flow rate (Vₙ) is greater than the recommended volume flow rate (V_{target}) (st. 404) and, upon determining that the detected flow rate (Vₙ) is greater than the recommended volume flow rate (V_{target}), adjusting the volume flow rate to a reduced level (Vₙ₊₁) that is less than the detected flow rate (Vₙ) (st. 406);
determining whether the reduced volume flow rate (Vₙ₊₁) is less than the predetermined minimum flow rate (Vₘᵢₙ) (st. 408) and, upon determining that the reduced volume flow rate (Vₙ₊₁) is less than the predetermined minimum flow rate (Vₘᵢₙ), adjusting the volume flow rate to the predetermined minimum flow rate (Vₘᵢₙ) (st. 410);
determining whether the detected flow rate (Vₙ) is less than the recommended volume flow rate (V_{target}) (st. 414) and, upon determining that the detected flow rate (Vₙ) is less than the recommended volume flow rate (V_{target}), adjusting the volume flow rate to an increased level (Vₙ₊₁) that is greater than the detected flow rate (Vₙ) (st. 416);
determining whether the increased volume flow rate level (Vₙ₊₁) results in an opened state of the volume flow valve (208) (st. 420) and, upon determining that the volume flow valve (208) is in an open state, send an alert message indicating that the volume flow valve (208) is in an open state but there exists an insufficient flow rate.

7. The dry cooling method of anyone of claim 6, wherein the volume flow valve (208) comprises a solenoid-controlled valve, a pressure independent control valve (PICV), or an automatic balancing pressure control valve (ABQM).

8. The dry cooling method of anyone of claims 1 to 7, further comprises monitoring (450) whether, after fully opening the volume flow valve (208), any flow rate issues of the cooling water to be applied to the evaporating pad (150) exist, by:
determining whether the volume flow valve (208) is in the fully open state (st. 454) and, upon determining that the volume flow valve (208) is in the fully open state, send an alert message indicating that the the volume flow valve (208) (st. 458) is fully open; and
determining whether the detected flow rate Vₙ is equal to a maximum flow rate of the volume flow valve V_{maxABQM} (st. 460) and, upon determining that the detected flow rate Vₙ is not equal to the valve maximum flow rate V_{maxABQM}, determine whether the detected flow rate Vₙ is less than the valve maximum flow rate V_{maxABQM} (st. 462), and upon determining that the detected flow rate Vₙ is less than the valve maximum flow rate V_{maxABQM}, sending an alert message indicating the detection of insufficient evaporative cooling water flow (st. 464),
wherein, upon determining that the detected flow rate Vₙ is not less than the valve maximum flow rate V_{maxABQM}, sending an alert message indicating the detection of a malfunction in flow detection and/or the volume flow valve (208) operations (st. 466).

9. The dry cooling method of claim 8, wherein, upon determining that the volume flow valve (208) is not in the fully open state, exiting the monitoring process (st. 456).

10. The dry cooling method of claims 8 or 9, wherein, upon determining that the detected flow rate Vₙ is equal to the valve maximum flow rate V_{maxABQM}, exiting the monitoring process (st. 468).

11. The dry cooling method of anyone of claims 1 to 10, wherein the method may be executed to operate at initial installation, to operate continuously, to operate periodically at predetermined intervals, and/or to operate upon detection of an anomaly.

## Amended claims

### Amended claims in accordance with Rule 137(2) EPC.

1. A datacenter dry cooling method (300, 400, 450) for cooling a heat-generating electronic processing source, the datacenter associated with a dry cooler unit (10) that incorporates liquid-to-air heat exchanger panel (20), an evaporating pad (150), and an evaporating cooling water distribution arrangement (200) including a flow control valve (208) for applying a controlled measured flow rate of cooling water to the evaporating pad (150), the method comprising:
at an air outlet surface of the evaporating pad, detecting temperature levels by at least one temperature sensor (212B, 214B) and/or at least one relative humidity sensor (212A, 214A) for detecting humidity levels;
at an air inlet surface of the evaporating pad, detecting temperature levels by at least one temperature sensor (232) and/or humidity levels by a relative humidity sensor (233);
detecting a leak from the evaporating pad by at least one leak sensor; and
a controller (500) communicatively-coupled to the temperature and humidity levels sensors disposed at the air outlet and air inlet surfaces of the evaporating pad, the leak sensor, and the evaporating cooling water distribution arrangement (200) and flow control valve (208), in which the controller (500) is configured to execute instructions for:
receiving the detected temperature and humidity levels from the sensors disposed at the air outlet and air inlet surfaces of the evaporating pad and the leak sensor;
determining whether a first detected temperature level (T_{mid}) from the air outlet surface is greater than a predetermined first threshold temperature value (T_{midtarget}) (St. 310) and, upon determining that the detected first temperature level is greater than the first threshold temperature value, adjusting a predetermined target volume flow rate (V_{target}) of the flow control valve (208) of the evaporating cooling water distribution arrangement (200) to a predetermined maximum flow rate (Vₘₐₓ) (st. 312);
determining whether a second detected temperature level from the air outlet surface (T_{low}) is greater than a second threshold temperature value (T_{lowupmax}) (st. 314) and, upon determining that the detected temperature level is greater than the second threshold temperature value, adjusting the predetermined the target volume flow rate (V_{target}) of the flow control valve (208) of the evaporating cooling water distribution arrangement (200) to the predetermined maximum flow rate (Vₘₐₓ) (st. 316);
determining whether the second detected temperature level (T_{low}) is less than a third threshold temperature value (T_{lowdownmin}) (st. 318) and, upon determining that the second detected temperature level is less than the third threshold temperature value, adjusting the predetermined the target volume flow rate (V_{target}) of the flow control valve (208) of the evaporating cooling water distribution arrangement (200) to a predetermined minimum flow rate (Vₘᵢₙ) (st. 320); and
determining whether a leak has been detected (st. 304) and, upon determining that a leak has been detected, sending an alert message indicating the detection of a leak (st. 306), and adjusting the predetermined target volume flow rate (V_{target}) of the evaporating cooling water distribution arrangement (200) to the predetermined minimum flow rate (Vₘᵢₙ) (st. 308).

2. The dry cooling method of claim 1, wherein:
a first temperature and/or humidity sensor (212A, 212B) is disposed along a first monitoring band (226) on the air outlet surface of the evaporating pad (150) to provide the first detected temperature level (T_{mid}); and
a second temperature and/or humidity sensor (214A, 214B) disposed along a second monitoring band (228) on the air outlet surface of the evaporating pad (150) to provide the second detected temperature level (T_{low}),
wherein the second monitoring band (228) is positioned lower than the first monitoring band (226).

3. The dry cooling method of claim 2, wherein:
the determining that the first detected temperature level (T_{mid}) is greater than the first threshold temperature value (T_{midtarget}) (st. 310) corresponds to the temperature level detected by the first temperature sensor (212B) along the first monitoring band (226); and
the determining that the second detected temperature level (T_{low}) is greater than the second threshold temperature value (T_{lowupmax}) (st. 314) or less than the third threshold temperature value (T_{lowdownmin}) (st. 318) corresponds to the temperature level detected by the second temperature sensor (214B) along the second monitoring band (228).

4. The dry cooling method of anyone of claims 1 to 3, wherein:
the predetermined first threshold temperature value (T_{midtarget}) is based on an empirically-derived constant or an empirically-derived function dependent on the detected temperature level at the air inlet surface of the evaporating pad (Tᵢ); and
the second threshold temperature value (T_{lowupmax}), the third threshold temperature value (T_{lowdownmin}), the predetermined minimum flow rate (Vₘᵢₙ), and the predetermined maximum flow rate (Vₘₐₓ) are based on the empirically-derived function dependent on the detected temperature level (Tᵢ) or humidity level (Rᵢ) at the air inlet surface.

5. The dry cooling method of anyone of claims 1 to 4, further comprising controlling the volume flow valve (208) of the evaporative cooling water distribution arrangement (200) for applying a controlled measured flow rate of the cooling water to the evaporating pad (150), by:
determining whether a detected flow rate (Vₙ) is greater than the recommended volume flow rate (V_{target}) (st. 404) and, upon determining that the detected flow rate (Vₙ) is greater than the recommended volume flow rate (V_{target}), adjusting the volume flow rate to a reduced level (Vₙ₊₁) that is less than the detected flow rate (Vₙ) (st. 406);
determining whether the reduced volume flow rate (Vₙ₊₁) is less than the predetermined minimum flow rate (Vₘᵢₙ) (st. 408) and, upon determining that the reduced volume flow rate (Vₙ₊₁) is less than the predetermined minimum flow rate (Vₘᵢₙ), adjusting the volume flow rate to the predetermined minimum flow rate (Vₘᵢₙ) (st. 410);
determining whether the detected flow rate (Vₙ) is less than the recommended volume flow rate (V_{target}) (st. 414) and, upon determining that the detected flow rate (Vₙ) is less than the recommended volume flow rate (V_{target}), adjusting the volume flow rate to an increased level (Vₙ₊₁) that is greater than the detected flow rate (Vₙ) (st. 416);
determining whether the increased volume flow rate level (Vₙ₊₁) results in an opened state of the volume flow valve (208) (st. 420) and, upon determining that the volume flow valve (208) is in an open state, send an alert message indicating that the volume flow valve (208) is in an open state but there exists an insufficient flow rate.

6. The dry cooling method of claim 5, wherein the volume flow valve (208) comprises a solenoid-controlled valve, a pressure independent control valve (PICV), or an automatic balancing pressure control valve (ABQM).

7. The dry cooling method of anyone of claims 1 to 6, further comprising monitoring (450) whether, after fully opening the volume flow valve (208), any flow rate issues of the cooling water to be applied to the evaporating pad (150) exist, by:
determining whether the volume flow valve (208) is in the fully open state (st. 454) and, upon determining that the volume flow valve (208) is in the fully open state, send an alert message indicating that the the volume flow valve (208) (st. 458) is fully open; and
determining whether the detected flow rate Vₙ is equal to a maximum flow rate of the volume flow valve V_{maxABQM} (st. 460) and, upon determining that the detected flow rate Vₙ is not equal to the valve maximum flow rate V_{maxABQM}, determine whether the detected flow rate Vₙ is less than the valve maximum flow rate V_{maxABQM} (st. 462), and upon determining that the detected flow rate Vₙ is less than the valve maximum flow rate V_{maxABQM}, sending an alert message indicating the detection of insufficient evaporative cooling water flow (st. 464),
wherein, upon determining that the detected flow rate Vₙ is not less than the valve maximum flow rate V_{maxABQM}, sending an alert message indicating the detection of a malfunction in flow detection and/or the volume flow valve (208) operations (st. 466).

8. The dry cooling method of claim 7, wherein, upon determining that the volume flow valve (208) is not in the fully open state, exiting the monitoring process (st. 456).

9. The dry cooling method of claims 8, wherein, upon determining that the detected flow rate Vₙ is equal to the valve maximum flow rate V_{maxABQM}, exiting the monitoring process (st. 468).

10. The dry cooling method of anyone of claims 1 to 9, wherein the method may be executed to operate at initial installation, to operate continuously, to operate periodically at predetermined intervals, and/or to operate upon detection of an anomaly.

11. A datacenter dry cooling system (200) for cooling a heat-generating electronic processing source, the datacenter associated with a dry cooler unit (10), comprising:
a liquid-to-air heat exchanger panel (20);
an evaporating pad (150);
an evaporating cooling water distribution arrangement (200) incorporating a flow control valve (208) for applying cooling water to the evaporating pad (150);
at least one temperature sensor (212B, 214B) disposed at an air outlet surface of the evaporating pad for detecting temperature levels and/or at least one relative humidity sensor (212A, 214A) for detecting humidity levels;
at least one temperature sensor (232) disposed at an air inlet surface of the evaporating pad for detecting temperature levels and/or at least on relative humidity sensor (233) for detecting humidity levels;
at least one leak sensor for detecting a leak from the evaporating pad; and
a controller (500) communicatively-coupled to the temperature and humidity levels sensors disposed at the air outlet and air inlet surfaces of the evaporating pad, the leak sensor, and the evaporating cooling water distribution arrangement (200) and flow control valve (208), in which the controller (500) is configured to execute instructions for:
receiving the detected temperature and humidity levels from the sensors disposed at the air outlet and air inlet surfaces of the evaporating pad and the leak sensor;
determining whether a first detected temperature level (T_{mid}) from the air outlet surface is greater than a predetermined first threshold temperature value (T_{midtarget}) (St. 310) and, upon determining that the detected first temperature level is greater than the first threshold temperature value, adjusting a predetermined target volume flow rate (V_{target}) of the flow control valve (208) to a predetermined maximum flow rate (Vₘₐₓ) (st. 312);
determining whether a second detected temperature level from the air outlet surface (T_{low}) is greater than a second threshold temperature value (T_{lowupmax}) (st. 314) and, upon determining that the detected temperature level is greater than the second threshold temperature value, adjusting the predetermined the target volume flow rate (V_{target}) of the flow control valve (208) to the predetermined maximum flow rate (Vₘₐₓ) (st. 316);
determining whether the second detected temperature level (T_{low}) is less than a third threshold temperature value (T_{lowdownmin}) (st. 318) and, upon determining that the second detected temperature level is less than the third threshold temperature value, adjusting the predetermined target volume flow rate (V_{target}) of the flow control valve (208) to a predetermined minimum flow rate (Vₘᵢₙ) (st. 320); and
determining whether a leak has been detected (st. 304) and, upon determining that a leak has been detected, sending an alert message indicating the detection of a leak (st. 306), and adjusting the predetermined target volume flow rate (V_{target}) of the flow control valve (208) to the predetermined minimum flow rate (Vₘᵢₙ) (st. 308).

12. The datacenter dry cooling system of claim 11, wherein:
a first temperature and/or humidity sensor (212A, 212B) is disposed along a first monitoring band (226) on the air outlet surface of the evaporating pad (150) to provide the first detected temperature level (T_{mid}); and
a second temperature and/or humidity sensor (214A, 214B) disposed along a second monitoring band (228) on the air outlet surface of the evaporating pad (150) to provide the second detected temperature level (T_{low}),
wherein the second monitoring band (228) is positioned lower than the first monitoring band (226).

13. The datacenter dry cooling system of claim 11, wherein:
the determining that the first detected temperature level (T_{mid}) is greater than the first threshold temperature value (T_{midtarget}) (st. 310) corresponds to the temperature level detected by the first temperature sensor (212B) along the first monitoring band (226); and
the determining that the second detected temperature level (T_{low}) is greater than the second threshold temperature value (T_{lowupmax}) (st. 314) or less than the third threshold temperature value (T_{lowdownmin}) (st. 318) corresponds to the temperature level detected by the second temperature sensor (214B) along the second monitoring band (228).
